# EUROPÄISCHE PATENTANMELDUNG

(11) **EP 3 546 314 A1**
(43) Veröffentlichungstag der Anmeldung: **02.10.2019**
(21) Anmeldenummer: 18164710.8
(22) Anmeldetag: 28.03.2018
(51) Int. Cl.: B61L 5/00, B61L 27/00

(54) **VERFAHREN UND VORRICHTUNG ZUR FEHLERIDENTIFIZIERUNG FÜR EIN TECHNISCHES SYSTEM**

(71) Anmelder: Siemens Aktiengesellschaft, 80333 München (DE)
(72) Erfinder: Boschert, Stefan, 85579 Neubiberg (DE); Heinrich, Christoph, 86609 Donauwörth (DE); Schulze, Michael, 12557 Berlin (DE)

(57) **Zusammenfassung**

Die Erfindung betrifft ein Verfahren und eine Vorrichtung (100) zur rechnergestützten Fehleridentifizierung für ein technisches System, umfassend eine Weiche und einen Weichenantrieb. Es wird ein Fehler oder eine Störung der Weiche und/oder des Weichenantriebs durch Erfassen eines Zeitverlaufs einer Messgröße des Weichenantriebs detektiert. Ein Simulationsmodell wird für das technische System bereitgestellt und eine Fehlersituation wird mittels Einstellwerten des Simulationsmodells, wobei die Einstellwerte der Fehlersituation zugeordnet sind, eingestellt. Das technische System wird mittels des Simulationsmodells simuliert, wobei ein simulierter Zeitverlauf der Messgröße erfasst wird. Der simulierte Zeitverlauf wird mit dem Zeitverlauf der Messgröße des Weichenantriebs verglichen, wobei abhängig vom Vergleich die Fehlersituation dem detektierten Fehler zugeordnet wird. Anhand der Einstellwerte des Simulationsmodells wird eine Fehlerursache des detektierten Fehlers identifiziert.

## Beschreibung

Die Erfindung betrifft ein Verfahren und eine Vorrichtung zur rechnergestützten Fehleridentifizierung für ein technisches System, umfassend eine Weiche und einen Weichenantrieb.

Weichen und Weichenantriebe sind im Schienenverkehr zentrale Elemente des Fahrwegs. Um einen Betriebsablauf möglichst dauerhaft zu gewährleisten, sind Anforderungen an die Funktionsfähigkeit des Systems Weiche-Weichentrieb in der Regel hoch. Störungen oder Fehler an der Weiche und/oder dem Weichenantrieb können den Betrieb des Schienenverkehrs stark einschränken.

Es ist bekannt eine Schieneninfrastruktur zu überwachen und beispielsweise mittels Sensoren die Funktionsfähigkeit einer Weiche und ihres Antriebs zu kontrollieren. Insbesondere sind Diagnosesysteme bekannt, welche mittels Sensoren, einer Auswerteeinheit und einem Rechner einen Fehler am System und/oder im Betrieb des Systems detektieren können. Dafür kann insbesondere eine Leistungsaufnahme des Weichenantriebs, d.h. ein zeitlicher Verlauf der aufgenommen Leistung beispielsweise während eines Stellvorgangs, überwacht werden. Ein Fehler, z.B. eine Blockade aufgrund eines Hindernisses in einer Weiche, kann beispielsweise erkannt werden, wenn eine Über- oder Unterschreitung der Leistungsaufnahme bezüglich eines vorgegebenen Schwellwertes vorliegt. Eine Fehlerbehebung kann in der Regel erst nach einer Inspektion und einer Suche nach der Fehlerursache, z.B. durch einen Servicetechniker, durchgeführt werden. Dies kann häufig sehr zeitaufwändig sein und eine Betriebsunterbrechung zur Folge haben. Außerdem ist die Identifizierung einzelner Fehlerursachen oft nicht praktikabel, da lediglich der Ergebniszustand des fehlerhaften Systems vorliegen kann.

Es ist eine Aufgabe der Erfindung, die Fehlerursachenidentifizierung für ein System aus einer Weiche und einem der Weiche zugeordneten Weichenantriebs zu ermöglichen und zu beschleunigen.

Die Aufgabe wird gelöst durch ein Verfahren mit den Merkmalen des Patentanspruchs 1, durch eine Vorrichtung mit den Merkmalen des Patentanspruchs 9, durch ein Computerprogrammprodukt mit den Merkmalen des Patentanspruchs 13 sowie durch ein computerlesbares Speichermedium mit den Merkmalen des Patentanspruchs 14. Vorteilhafte Ausführungsformen und Weiterbildungen der Erfindung sind in den abhängigen Ansprüchen angegeben.

Ein erster Aspekt betrifft ein Verfahren zur rechnergestützten Fehleridentifizierung für ein technisches System, umfassend eine Weiche und einen Weichenantrieb, mit den Verfahrensschritten:
- Detektieren eines Fehlers der Weiche und/oder des Weichenantriebs durch Erfassen eines Zeitverlaufs einer Messgröße des Weichenantriebs,
- Bereitstellen eines Simulationsmodells für das technische System und Einstellen einer Fehlersituation mittels der Einstellwerten des Simulationsmodells, wobei die Einstellwerte der Fehlersituation zugeordnet sind,
- Simulieren des technischen Systems mittels des Simulationsmodells, wobei ein simulierter Zeitverlauf der Messgröße erfasst wird,
- Vergleichen des simulierten Zeitverlauf der Messgröße mit dem Zeitverlaufs der Messgröße des Weichenantriebs, wobei abhängig vom Vergleichsergebnis die Fehlersituation dem detektierten Fehler zugeordnet wird,
- Identifizieren einer Fehlerursache des detektierten Fehlers anhand der Einstellwerte des Simulationsmodells und abhängig vom Vergleichsergebnis,
- Ausgeben der identifizierten Fehlerursache.

Es ist ein Vorteil des erfindungsgemäßen Verfahrens, dass mittels einer Simulation des technischen Systems, welches eine Weiche und mindestens einen Weichenantrieb umfasst, eine Identifizierung der Ursache eines detektierten Fehlers des technischen Systems erfolgen kann. Die Erfindung ist insbesondere auf Schienensysteme gerichtet, wie z.B. Eisenbahnweichen- und antriebe. Es kann insbesondere eine Fehleridentifizierung aus der Ferne, d.h. ohne lokale Untersuchung des technischen Systems, erfolgen. Dies ermöglicht beispielsweise eine schnellere Wartung der Weiche und des Weichenantriebs bei einer Störung und kann insbesondere eine längere Betriebsunterbrechung verhindern

Insbesondere kann das technische System unter einer bekannten Fehlerbedingung simuliert werden. Abhängig vom Vergleichsergebnis, insbesondere wenn der simulierte Zeitverlauf mit dem gemessenen Zeitverlauf der Messgröße innerhalb z.B. eines Toleranzbereichs übereinstimmt, kann eine simulierte Fehlersituation dem detektierten Fehler zugeordnet werden.

Unter "rechnergestützt" kann im Zusammenhang mit der Erfindung beispielsweise eine Implementierung des Verfahrens verstanden werden, bei dem insbesondere ein Prozessor mindestens einen Verfahrensschritt des Verfahrens ausführt.

Es kann ein Fehler oder eine Störung am System Weiche-Weichenantrieb mittels Überwachung eines Zeitverlaufs einer Messgröße des Weichenantriebs erkannt werden. Beispielsweise kann die Leistungsaufnahme des Weichenantriebs überwacht werden und ein Fehler detektiert werden, wenn die Leistungsaufnahme einen Schwellwert über- oder unterschreitet. Eine schnelle Analyse der Fehlerursache, beispielsweise eine Analyse in Echtzeit, kann mittels einer Simulation des Systems erfolgen.

Es wird ein Simulationsmodell der Weiche und des mindestens einen Weichenantriebs bereitgestellt. Für die Identifizierung der Fehlerursache kann mittels des Simulationsmodells eine vorgegebene Fehlersituation, z.B. eine Blockade des Stellvorgangs der Weiche durch ein Hindernis, simuliert werden. Unter "Fehlersituation" kann beispielsweise eine Kombination aus einer oder mehreren einzelnen Fehlerursachen verstanden werden, wobei Einstellwerte des Simulationsmodels der Fehlersituation zugeordnet sind. In anderen Worten, die Fehlersituation kann auf einzelnen Fehlerursachen basieren. Eine Fehlerursache kann aus den Einstellwerten abgeleitet werden.

Es kann eine Simulation des technischen Systems unter Berücksichtigung der Fehlersituation erfolgen und ein simulierter, zeitlicher Verlauf einer Messgröße erfasst werden. Vorzugsweise wird eine Messgröße in der Simulation untersucht, für die eine Messung bzw. ein Zeitverlauf des realen technischen Systems vorliegt. Die Fehlersituation kann vorzugsweise vorgegeben und mittels Einstellwerten für das Simulationsmodel eingestellt werden. Insbesondere können die Einstellwerte der Fehlersituation zugeordnet sein und dadurch eine Fehlerursache, wie z.B. ein Hindernis in der Weiche oder Schwergang einzelner beweglicher Teile, wiedergeben. Demnach können die Einstellwerte des Simulationsmodells gewählt werden, diese Fehlersituation zu reproduzieren.

Die Stellvorgänge der Weiche können mittels des Simulationsmodells simuliert und aus der Simulation der Zeitverlauf einer Messgröße ermittelt werden. Abhängig vom Vergleich mit dem Zeitverlauf der Messgröße des realen Weichenantriebs kann eine Fehlerursache identifiziert werden. Es können beispielsweise eine gemessene und eine simulierte Lastkurve miteinander verglichen werden. Beispielsweise kann der Vergleich eine Übereinstimmung der beiden Zeitverläufe innerhalb eines vorgegebenen Wertebereichs ergeben und die Fehlersituation kann als Ursache für den detektierten Fehler bestimmt bzw. diesem zugeordnet werden. Anhand der Einstellwerte des Simulationsmodells können mehrere Fehlerursachen ermittelt und ausgegeben werden. Es ist möglich, dem Vergleich einen Wahrscheinlichkeitswert zuzuordnen, auf dessen Basis eine Identifizierung der Fehlerursache erfolgen kann.

In vorteilhafter Ausführungsform des Verfahrens kann das Simulationsmodell eine elektronische und/oder mechanische Komponente der Weiche und des Weichenantriebs abbilden.

Das Simulationsmodell des technischen Systems, umfassend eine Weiche und mindestens einen Weichenantrieb, kann insbesondere eine detaillierte Modellierung der Mechanik und/oder Elektronik des Systems umfassen. Vorzugsweise kann mittels des Simulationsmodells die Physik und die Wirkprinzipien des technischen Systems abgebildet und damit Fehlersituationen analysiert werden. Es können Stellvorgänge der Weiche simuliert und daraus der Zeitverlauf einer Messgröße ermittelt werden.

In einer vorteilhaften Ausführungsform können mehr als eine Fehlersituation eingestellt und jeweils der simulierte Zeitverlauf der Messgröße erfasst werden und, anhand des Vergleichs jeweils mit dem Zeitverlauf der Messgröße des Weichenantriebs, derjenige simulierte Zeitverlauf mit einer kleinsten Abweichung selektiert werden.

Vorzugsweise können mehr als eine Fehlersituation bereitgestellt und mittels zugeordneten Einstellwerten am Simulationsmodell eingestellt werden. Es können vorzugsweise mehrere Fehlersituationen des technischen Systems nacheinander eingestellt und simuliert werden. In anderen Worten, das technische System kann mehrfach unter verschiedenen, bekannten Fehlerbedingungen simuliert werden. Für jede Simulation mit eingestellter Fehlersituation kann entsprechend jeweils ein simulierter Zeitverlauf der Messgröße ermittelt werden. Anhand eines Vergleichs mit dem gemessenen Zeitverlauf der Messgröße des Weichenantriebs kann diejenige simulierte Fehlersituation ermittelt werden, deren zugeordneter simulierter Zeitverlauf die kleinste Abweichung zum gemessenen Zeitverlauf zeigt, d.h. beispielsweise im Vergleich die beste Übereinstimmung zeigt. Beispielsweise kann aus der Abweichung ein Wahrscheinlichkeitswert ermittelt werden, der die Wahrscheinlichkeit, dass eine Fehlerursache dem detektierten Fehler zugeordnet werden kann, angibt. Vorzugsweise kann mittels dieser Ausführungsform des Verfahrens die Fehlerursache ermittelt werden, die dem detektierten Fehler mit hoher Wahrscheinlichkeit zugrunde liegt.

In vorteilhafter Ausführungsform kann eine fehlerhafte Komponente des technischen Systems anhand des simulierten Zeitverlaufs der Messgröße und der identifizierten Fehlerursache ermittelt werden.

Vorzugsweise kann das Simulationsmodell einzelne Software- und/oder Hardware-Komponenten des technischen Systems abbilden. Abhängig von den Einstellwerten, die der Fehlersituation zugeordnet sind, kann eine Komponente des technischen Systems identifiziert werden, wo beispielsweise der Fehler auftritt oder welche fehlerhaft ist.

In einer vorteilhaften Ausführungsform können mittels eines Detektionsmoduls Sensordaten als Messgrößen des technischen Systems erfasst und ausgewertet werden.

Vorzugsweise umfasst das technische System Sensoren zur Überwachung von Messgrößen der einzelnen Komponenten, z.B. des Weichenantriebs. Ein Detektionsmodul kann beispielsweise die Sensordaten erfassen und auswerten und aus der Auswertung einen Fehler am technischen System ermitteln. Vorzugsweise erfolgt die Überwachung des technischen Systems fortlaufend und die Auswertung der Sensordaten zeitnah oder in Echtzeit.

In einer vorteilhaften Ausführungsform kann das Simulationsmodell anhand einer Konfiguration und/oder anhand von Einsatzbedingungen und/oder von Umgebungsdaten und/oder Sensordaten des technischen Systems erstellt und/oder kalibriert werden.

Vorzugsweise kann das Simulationsmodell vor der Simulation des Systems an reale Bedingungen angepasst und entsprechend kalibriert werden. Beispielsweise können Sensordaten aktuelle Informationen über das zu simulierende technische System liefern, welche mittels Einstellwerten des Simulationsmodells eingestellt werden können. Die Simulation kann somit insbesondere das reale System, wie z.B. besondere Eigenschaften, abbilden. Damit kann die Suche nach der Fehlerursache verbessert werden.

In einer vorteilhaften Ausführungsform können mittels der Ausgabe der identifizierten Fehlerursache Maßnahmen für die Fehlerbehebung an der Weiche und/oder am Weichenantrieb ermittelt und eingeleitet werden.

Die Ausgabe der identifizierten Fehlerursache kann zur Einleitung von Maßnahmen zur Behebung des Fehlers genutzt werden. Beispielsweise kann anhand der Fehlerursache eine geeignete Maßnahme ermittelt und/oder eine fehlerhafte Komponente identifiziert werden. Damit kann eine schnelle Wartung erzielt werden. Insbesondere für ein schwer zugängliches Weichensystem kann somit eine effiziente Fernwartung erfolgen.

In einer vorteilhaften Ausführungsform kann die identifizierte Fehlerursache in einer Datenbank und/oder in einer Speichereinheit gespeichert werden.

Die identifizierte Fehlerursache kann vorzugsweise in einer Liste oder einem Katalog erfasst werden. Die gespeicherte Fehlerursache kann beispielsweise bei zukünftigen Störungen desselben oder eines ähnlichen technischen Systems für die Suche nach einer Fehlerursache herangezogen werden. Beispielsweise kann zusätzlich eine Beschreibung der identifizierten Fehlerursache, wie z.B. der Umgebungsinformationen, gespeichert werden. Es ist auch möglich, dass gespeicherte Fehlerursachen als Eingabe für eine nachfolgende Fehleridentifizierung, in Form einer Fehlersituation, für das Simulationsmodell genutzt werden. Mit bekannten Eingaben kann die Fehleridentifizierung mittels Simulation beschleunigt werden.

Ein weiterer Aspekt der Erfindung betrifft eine Vorrichtung zur rechnergestützten Fehleridentifizierung für ein technisches System, umfassend eine Weiche und einen Weichenantrieb, umfassend:
- ein Detektionsmodul zum Detektieren eines Fehlers der Weiche und/oder des Weichenantriebs durch Erfassen eines Zeitverlaufs einer Messgröße des Weichenantriebs,
- ein Simulationsmodul zum Bereitstellen eines Simulationsmodells für das technische System und Einstellen einer Fehlersituation mittels Einstellwerten des Simulationsmodells, wobei die Einstellwerte der Fehlersituation zugeordnet sind, und Simulieren des technischen Systems mittels des Simulationsmodells, wobei ein simulierter Zeitverlauf der Messgröße erfasst wird,
- Vergleichsmodul zum Vergleichen des simulierten Zeitverlaufs der Messgröße mit dem Zeitverlauf der Messgröße des Weichenantriebs, wobei abhängig vom Vergleichsergebnis die Fehlersituation dem detektierten Fehler zugeordnet wird,
- Identifikationsmodul zum Identifizieren einer Fehlerursache des detektierten Fehlers anhand der Einstellwerte des Simulationsmodells und abhängig vom Vergleichsergebnis,
- ein Ausgabemodul zum Ausgeben der identifizierten Fehlerursache.

Insbesondere kann eine erfindungsgemäße Vorrichtung als Software- und oder Hardwaremodul ausgestaltet sein.

In einer vorteilhaften Ausführungsform umfasst die Vorrichtung Sensoren zum Erfassen von Sensordaten des technischen Systems.

Sensoren erfassen vorzugsweise kontinuierlich und/oder regelmäßig Zeitverläufe von Messgrößen des technischen Systems. Beispielsweise kann mittels eines Sensors am Weichenantrieb eine Leistungsaufnahme über die Zeit erfasst werden.

In einer vorteilhaften Ausführungsform kann das Simulationsmodul derart eingerichtet sein, das Simulationsmodell anhand einer Konfiguration und/oder anhand von Einsatzbedingungen und/oder Umgebungsdaten und/oder Sensordaten des technischen Systems zu erstellen und/oder zu kalibrieren.

In einer vorteilhaften Ausführungsform umfasst die Vorrichtung eine Speichereinheit und/oder eine Datenbank zum Speichern einer identifizierten Fehlerursache.

Ein weiterer Aspekt der Erfindung betrifft ein Computerprogrammprodukt, das direkt in einen programmierbaren Computer ladbar ist, umfassend Programmcodeteile, die dazu geeignet sind, die Schritte des erfindungsgemäßen Verfahrens durchzuführen und ein computerlesbares Speichermedium.

Ausführungsbeispiele des erfindungsgemäßen Verfahrens und der Vorrichtung sind in den Zeichnungen beispielhaft dargestellt und werden nachfolgend näher erläutert. Es zeigen in schematischer Darstellung:
- Fig. 1: ein Ausführungsbeispiel des erfindungsgemäßen Verfahrens zur rechnergestützten Fehleridentifikation für ein technisches System als Ablaufdiagramm;
- Fig. 2: ein weiteres Ausführungsbeispiel des erfindungsgemäßen Verfahrens zur rechnergestützten Fehleridentifikation für ein technisches System als Ablaufdiagramm;
- Fig. 3: ein Ausführungsbeispiel der erfindungsgemäßen Vorrichtung zur rechnergestützten Fehleridentifikation für ein technisches System in Blockdarstellung.

Einander entsprechende Gegenstände sind in allen Figuren mit den gleichen Bezugszeichen versehen.

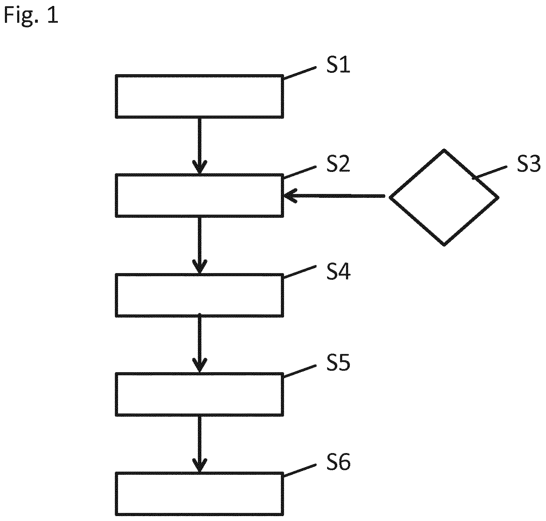

In Figur 1 ist ein Ausführungsbeispiel der Schritte des erfindungsgemäßen Verfahrens als Ablaufdiagramm gezeigt. Das Ausführungsbeispiel bezieht sich auf ein Schienensystem, welches eine Weiche und einen Weichenantrieb umfasst. Mittels eines Detektionsmoduls wird in Schritt S1 ein Fehler oder eine Störung am System erfasst. Beispielsweise kann der Fehler einen Ausfall der Weichensteuerung hervorrufen, so dass Sensoren am Weichenantrieb im Zeitverlauf der Leistungsaufnahme einen Abfall detektieren. Der detektierte Fehler umfasst beispielsweise den Ausfall des Weichensystems. Die Sensoren können beispielsweise auch Temperatur, Druck, Beschleunigung, oder Spannung erfassen.

In Schritt S2 wird ein Simulationsmodell des technischen Systems, umfassend die Weiche und den zugehörigen Weichenantrieb, bereitgestellt. Das Simulationsmodell kann anhand einer Konfiguration und/oder anhand von Einsatzbedingungen und/oder von Umgebungsdaten und/oder Sensordaten des technischen Systems eingestellt werden. In anderen Worten, Einstellwerte des Simulationsmodells können an das zu simulierende System angepasst werden. Insbesondere kann ein Simulationsmodell an ein bestimmtes Weiche-Weichenantrieb-System, z.B. mit besonderen Umgebungsbedingungen oder einem bestimmten Wartungszustand, angepasst werden.

Es wird eine Fehlersituation vorgegeben, welche durch das Einstellen der Einstellwerte des Simulationsmodells, eingerichtet wird. Es wird das technische System mittels des Simulationsmodells, bei dem die Fehlersituation eingestellt ist, simuliert. Beispielsweise kann ein Stellvorgang einer Weiche simuliert werden, wobei die Fehlersituation ein Hindernis in der Weiche umfasst. Folglich wird in Schritt S3 die Simulation unter Berücksichtigung des Hindernisses durchgeführt und ein simulierter Zeitverlauf einer Messgröße, wie z.B. Leistungsaufnahme, erfasst.

Im Schritt S4 wird der simulierte Zeitverlauf der Messgröße mit dem gemessenen Zeiterlauf, der z.B. von einem Sensor kontinuierlich bereitgestellt wird, verglichen. Eine Fehlersituation kann einem detektierten Fehler zugeordnet werden, wenn eine Abweichung zwischen den beiden Zeitverläufe in einen vorgegebenen Toleranzbereich fällt. In anderen Worten, bei einer bestimmten Ähnlichkeit der Zeitverläufe kann, mit einer bestimmten Wahrscheinlichkeit, mit der simulierten Fehlersituation der detektierte Fehler erklärt werden.

Ergibt der Vergleich, dass die vorgegebene Fehlersituation einen simulierten Zeitverlauf ergibt, welcher den gemessen Zeitverlauf reproduzieren kann, kann aus der Fehlersituation mindestens eine Fehlerursache ermittelt werden. Im Schritt S5 wird dazu anhand des Vergleichs ermittelt, dass die Fehlersituation, z.B. mit einer Wahrscheinlichkeitsangabe, die Ursache des detektierten Fehlers ist und anhand der Einstellwerte kann die mindestens eine Fehlerursache identifiziert werden.

Die identifizierte Fehlerursache wird im Schritt S6 ausgegeben. Daraufhin können Maßnahmen zur Fehlerbehebung eingeleitet werden. Insbesondere können anhand des Vergleichs einzelne fehlerhafte Komponenten des technischen Systems ermittelt werden, so dass Maßnahmen lediglich für diese Komponente abgeleitet und umgesetzt werden können.

Das erfindungsgemäße Verfahren kann beispielsweise auch für eine frühzeitige Fehlererkennung genutzt werden, wenn beispielsweise ein anormaler Zeitverlauf einer Messgröße von einem Sensor erfasst wird, dabei aber kein Fehler detektiert wird. Beispielsweise kann bereits eine Änderung des Zeitverlaufs einer Messgröße auf einen künftigen Fehler hindeuten. Durch Vergleich mit einem simulierten Zeitverlauf, gemäß vorgegebener Fehlersituation, können Fehlerursachen ermittelt werden, bevor gravierende Störungen, wie z.B. Betriebsausfälle, auftreten.

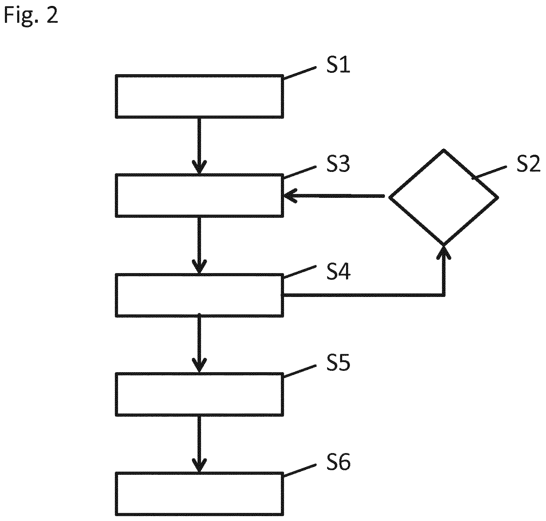

Figur 2 zeigt ein weiteres Ausführungsbeispiel des erfindungsgemäßen Verfahrens als Ablaufdiagramm. Die einzelnen Verfahrensschritte sind analog zu den beschriebenen Schritten in Figur 1. Es kann nach dem Vergleich des simulierten Zeitverlaufs mit dem gemessenen Zeitverlauf einer Messgröße, siehe Schritt S4, erneut eine Fehlersituation vorgegeben und die Simulation durchgeführt werden, siehe Schritt S2 und S3. Beispielsweise kann der Vergleich ergeben, dass die gewählte Fehlersituation einen simulierten Zeitverlauf ergibt, welcher den gemessenen Zeitverlauf nicht innerhalb eines Toleranzbereiches reproduzieren kann. Um die Fehleridentifizierung zu optimieren, können die Schritte S2 bis S4 mit verschiedenen Fehlersituationen beliebig oft wiederholt werden. Damit kann diejenige Fehlersituation ermittelt werden, deren Simulation den detektierten Fehler derart reproduzieren kann, dass die Abweichung zwischen dem simulierten und gemessenen Zeitverlauf der Messgröße am kleinsten ist.
In anderen Worten, vorzugsweise wird diejenige Fehlersituation selektiert, für welche der simulierte Zeitverlauf die geringste Abweichung zum gemessenen Zeitverlauf der entsprechenden Messgröße zeigt.

Beispielsweise können ermittelte Fehlersituationen in einer Datenbank und/oder Speichereinheit gespeichert werden und für eine, insbesondere spätere, Analyse eines detektierten Fehlers herangezogen werden.

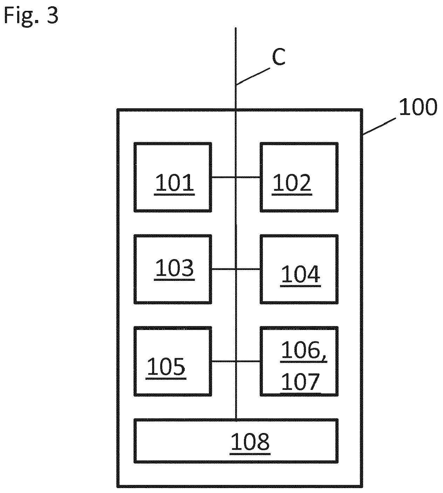

Figur 3 zeigt ein Ausführungsbeispiel der erfindungsgemäßen Vorrichtung (100) in Blockdarstellung. Die Vorrichtung (100) umfasst ein Detektionsmodul (101), ein Simulationsmodul (102), ein Vergleichsmodul (103), ein Identifikationsmodul (104), ein Ausgabemodul (105) und eine Speichereinheit (106) oder Datenbank (107). Vorzugsweise umfasst die Vorrichtung einen Prozessor (108) zum Durchführen mindestens eines Schrittes des erfindungsgemäßen Verfahrens. Die einzelnen Module sind vorzugsweise kabelgebunden oder drahtlos miteinander verbunden. Über eine Kommunikationsverbindung C ist die Vorrichtung vorzugsweise mit dem realen System Weiche-Weichenantrieb und/oder mit Sensoren des Systems verbunden.

Die Vorrichtung kann insbesondere Sensoren zur Überwachung von Messgrößen am technischen System umfassen. Mittels des Detektionsmoduls (101) kann ein Fehler anhand eines gemessenen Zeitverlaufs einer Messgröße detektiert werden.

Das Simulationsmodul (102) ist derart eingerichtet, ein Simulationsmodell der Mechanik des technischen Systems, insbesondere der Komponenten der Weiche und des Weichenantriebs, bereitzustellen und damit eine Simulation des Systems durchzuführen. Anhand der Simulation kann ein simulierter Zeitverlauf einer Messgröße ermittelt werden.

Das Vergleichsmodul (103) ermittelt die Abweichung des simulierten Zeitverlaufs vom gemessenen Zeitverlauf einer Messgröße und gibt beispielsweise einen Übereinstimmungsgrad oder einen Wahrscheinlichkeitswert aus. Beispielsweise kann mittels statistischer Verfahren die Abweichung der beiden Zeitverläufe untersucht werden.

Abhängig vom Vergleichsergebnis gibt das Identifikationsmodul (104) eine Fehlersituation als Ursache für den detektierten Fehler aus. Anhand der Einstellwerte des Simulationsmodells, welche der Fehlersituation zugeordnet sind, können eine oder mehrere Fehlerursachen identifiziert werden.

Das Ausgabemodul (105) gibt die eine oder mehreren identifizierten Fehlerursachen aus. Beispielsweise werden die Fehlerursachen in der Speichereinheit (106) und/oder Datenbank (107) gespeichert. Anhand der Fehlerursachen können Maßnahmen zur Fehlerbehebung abgeleitet werden.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt.

## Patentansprüche

1. Verfahren zur rechnergestützten Fehleridentifizierung für ein technisches System, umfassend eine Weiche und einen Weichenantrieb, mit den Verfahrensschritten:
- Detektieren (S1) eines Fehlers der Weiche und/oder des Weichenantriebs durch Erfassen eines Zeitverlaufs einer Messgröße des Weichenantriebs,
- Bereitstellen (S2) eines Simulationsmodells für das technische System und Einstellen einer Fehlersituation mittels Einstellwerten des Simulationsmodells, wobei die Einstellwerte der Fehlersituation zugeordnet sind,
- Simulieren (S3) des technischen Systems mittels des Simulationsmodells, wobei ein simulierter Zeitverlauf der Messgröße erfasst wird,
- Vergleichen (S4) des simulierten Zeitverlaufs der Messgröße mit dem Zeitverlauf der Messgröße des Weichenantriebs, wobei abhängig vom Vergleichsergebnis die Fehlersituation dem detektierten Fehler zugeordnet wird,
- Identifizieren (S5) einer Fehlerursache des detektierten Fehlers anhand der Einstellwerte des Simulationsmodells und abhängig vom Vergleichsergebnis,
- Ausgeben (S6) der identifizierten Fehlerursache.

2. Verfahren nach Anspruch 1, wobei das Simulationsmodell eine elektronische und/oder mechanische Komponente der Weiche und des Weichenantriebs abbildet.

3. Verfahren nach einem der vorangehenden Ansprüche, wobei mehr als eine Fehlersituation eingestellt und jeweils der simulierte Zeitverlauf der Messgröße erfasst wird und, anhand des Vergleichs jeweils mit dem Zeitverlauf der Messgröße des Weichenantriebs, derjenige simulierte Zeitverlauf mit einer kleinsten Abweichung selektiert wird.

4. Verfahren nach einem der vorangehenden Ansprüche, wobei eine fehlerhafte Komponente des technischen Systems anhand des simulierten Zeitverlaufs der Messgröße und der identifizierten Fehlerursache ermittelt wird.

5. Verfahren nach einem der vorangehenden Ansprüche, wobei mittels eines Detektionsmoduls Sensordaten als Messgrößen des technischen Systems erfasst und ausgewertet werden.

6. Verfahren nach einem der vorangehenden Ansprüche, wobei das Simulationsmodell anhand einer Konfiguration und/oder anhand von Einsatzbedingungen und/oder von Umgebungsdaten und/oder Sensordaten des technischen Systems erstellt und/oder kalibriert wird.

7. Verfahren nach einem der vorangehenden Ansprüche, wobei mittels der Ausgabe der identifizierten Fehlerursache Maßnahmen für die Fehlerbehebung an der Weiche und/oder am Weichenantrieb ermittelt und eingeleitet werden.

8. Verfahren nach einem der vorangehenden Ansprüche, wobei die identifizierte Fehlerursache in einer Datenbank und/oder in einer Speichereinheit gespeichert wird.

9. Vorrichtung (100) zur rechnergestützten Fehleridentifizierung für ein technisches System, umfassend eine Weiche und einen Weichenantrieb, umfassend:
- ein Detektionsmodul (101) zum Detektieren eines Fehlers der Weiche und/oder des Weichenantriebs durch Erfassen eines Zeitverlaufs einer Messgröße des Weichenantriebs,
- ein Simulationsmodul (102) zum Bereitstellen eines Simulationsmodells für das technische System und Einstellen einer Fehlersituation mittels Einstellwerten des Simulationsmodells, wobei die Einstellwerte der Fehlersituation zugeordnet sind, und Simulieren des technischen Systems mittels des Simulationsmodells, wobei ein simulierter Zeitverlauf der Messgröße erfasst wird,
- Vergleichsmodul (103) zum Vergleichen des simulierten Zeitverlaufs der Messgröße mit dem Zeitverlauf der Messgröße des Weichenantriebs, wobei abhängig vom Vergleichsergebnis die Fehlersituation dem detektierten Fehler zugeordnet wird,
- Identifikationsmodul (104) zum Identifizieren einer Fehlerursache des detektierten Fehlers anhand der Einstellwerte des Simulationsmodells und abhängig vom Vergleichsergebnis,
- ein Ausgabemodul (105) zum Ausgeben der identifizierten Fehlerursache.

10. Vorrichtung nach Anspruch 9 umfassend Sensoren zum Erfassen von Sensordaten des technischen Systems.

11. Vorrichtung nach Anspruch 9 oder 10, wobei das Simulationsmodul derart eingerichtet ist, das Simulationsmodell anhand einer Konfiguration und/oder anhand von Einsatzbedingungen und/oder Umgebungsdaten und/oder Sensordaten des technischen Systems zu erstellen und/oder zu kalibrieren.

12. Vorrichtung nach einem der Ansprüche 8 bis 11, umfassend eine Speichereinheit (106) und/oder eine Datenbank (107) zum Speichern einer identifizierten Fehlerursache.

13. Computerprogrammprodukt, das direkt in einen programmierbaren Computer ladbar ist, umfassend Programmcodeteile, die dazu geeignet sind, die Schritte des Verfahrens nach einem der Ansprüche 1 bis 8 durchzuführen.

14. Computerlesbares Speichermedium mit einem Computerprogrammprodukt nach Anspruch 13.
